Europäisches Patentamt

(19) **European Patent Office**

**Office européen des brevets**

(11) Publication number: **0 027 017**
**B1**

# EUROPEAN PATENT SPECIFICATION

(45) Date of publication of patent specification: **14.03.84**

(51) Int. Cl.³: **H 01 L 23/08** //H01L23/14, H01L23/54

(21) Application number: **80303416.4**

(22) Date of filing: **29.09.80**

(54) Integrated circuit package.

(30) Priority: **04.10.79 JP 128199/79**

(43) Date of publication of application:
**15.04.81 Bulletin 81/15**

(45) Publication of the grant of the patent:
**14.03.84 Bulletin 84/11**

(84) Designated Contracting States:
**DE FR GB NL**

(56) References cited:
**DE - A - 1 952 789**
**GB - A - 1 115 302**

**SOLID STATE TECHNOLOGY, vol. 14, no. 5, May 1971, pages 47-50 Washington, U.S.A. B.M. HARGIS: "Buried wire multilayer ceramics"**

(73) Proprietor: **FUJITSU LIMITED**
**1015, Kamikodanaka Nakahara-ku Kawasaki-shi Kanagawa 211 (JP)**

(72) Inventor: **Akasaki, Hidehiko**
**c/o Saharaso, 274 Kamikodanaka Nakahara-ku Kawasaki-shi Kanagawa 211 (JP)**

(74) Representative: **Bedggood, Guy Stuart et al, Haseltine Lake & Co. Hazlitt House 28 Southampton Buildings Chancery Lane London WC2A 1AT (GB)**

Courier Press, Leamington Spa, England.

## Chip carrier for a semiconductor device

The present invention relates to a chip carrier for a semiconductor device according to the precharacterizing portion of claim 1.

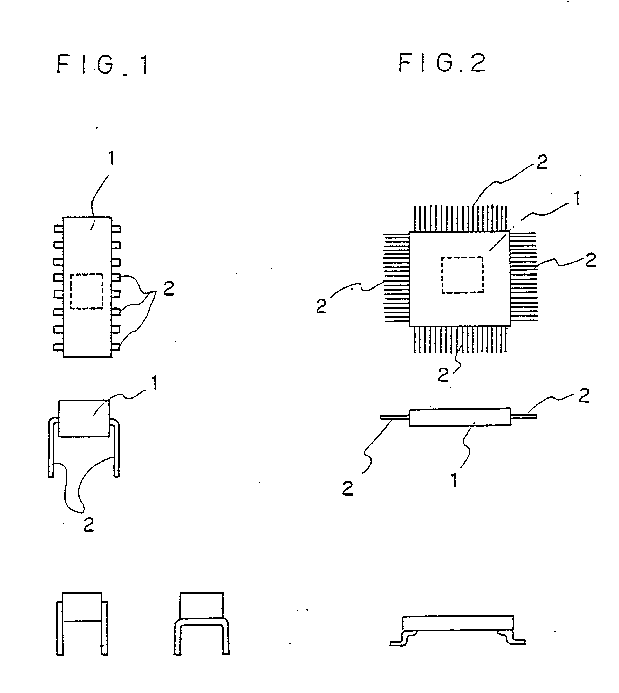

In the art of electronics packaging dual in-line packages (DIP), flat packages (FP) and plug-in packages (PIP) have been widely used. In Fig. 1, of the accompanying drawings front and side views of a typical DIP are shown at the top of and in the middle of the Figure respectively. This type of DIP has been of significant utility in packaging hybrid integrated circuits and varieties of IC chips. As is generally known, a cavity shown in the front view at the top of Fig. 1 by a broken line square is provided in an insulator body 1 made of alumina ceramic. The cavity receives an IC chip. After the chip has been secured in the cavity, lead wires are bonded, by a known wire bonding technique, to electrodes at the periphery or edge of the chip to connect the electrodes to metallized layers on the ceramic substrate. The metal layers are brazed to radially arranged terminals 2 made of ferro-nickel alloy, for example, to be led to outside (external) wiring. The DIP is characterized by two rows of terminals 2; each terminal 2 is of substantially L-shaped configuration as shown in the side view of Fig. 1. The number of terminals and the centreline spacing depend on the packing density and the function of the IC, but an array of 40 terminals with centerline spacing of 1.27 mm or 2.54 mm is commonly used. Mounting on a printed circuit board is effected by means of wave soldering or flow soldering. In the lower part of Fig. 1 there are shown in two side-views of respective modified DIPs which are also used in the industry.

At the top of Fig. 2 of the accompanying drawings a front view of a flat package (FP) used to encase a small sized chip such as an LSI chip is shown. A flat and substantially square ceramic body 1 is formed with a cavity, shown by a broken line square, for the chip. The ceramic substrate is formed with the wiring pattern prepared by means of a screen print which is brazed to terminals 2 for the purpose of connecting the electrodes of the chip to outside wiring. The flat package is distinguished in that it is more miniaturized than the DIP, and consequently the resistance of substrate wiring is accordingly low. In the middle of Fig. 2 a side-view of the FP is shown, and at the bottom of Fig. 2, a side-view of a modified FP is shown.

In addition to DIP's and FP's plug in packages (PIP), not shown, but mentioned in Table 1 below have been used. Whereas terminals extend horizontally from the ceramic body of a FP, terminals of a PIP are formed by an array of pins of circular cross-section which extend vertically from the bottom of the ceramic body encasing a chip.

Known packages described so far are more or less standardized in their design and in the dimensions of their terminals, considering the design requirements of systems using IC packages, the ease of mounting of the packages and circuit assembly. However, the number of terminals per package, which is in the order of 64, is rather too small to meet current demands. Where a large number of terminals are required, as is the case with LSI chips which integrate a large number of logic devices, the consequence of using known packages described so far is that either it becomes difficult to encase the LSI chip or the operational functions of an encased LSI chip cannot fully be exhibited. In other words, the performance of a chip in a DIP is governed primarily by limitations on the number of terminals required and not by limitations on the size of the LSI chip. Further, where side notches are formed on four edges of a package with a centreline spacing of 40 to 50 mil, there is a danger of solder bridging when terminals are soldered.

Multi-layer ceramics or ceramic chip carriers are replacing DIP, FP and PIP where LSI chips are involved. Such a chip carrier is a substantially square package for an integrated circuit. It is made with practically the same materials and processes that have been used in making ceramic DIP's. The chip carrier may be understood as being equivalent to the centre portion of the DIP with the two rows of metal leads replaced by contact pads on all four sides thereof. The design of the chip carrier requires a high density of interconnection at the substrate level. In a typical multi-layer ceramic substrate or carrier, top layers are used to distribute signal lines from the chip pad grid, first to the top surface then to the internal wiring grid. The centre layers of the substrate contain X—Y wiring planes. The bottom layers are used for power distribution and signal redistribution. Via holes (or through holes) between layers allow true three dimensional wiring. An array of pins is formed on the bottom of the substrate or carrier for connecting the carrier to a mother board.

The chip carrier was designed as a leadless package to be connected to a mother board by soldering. The solder makes electrical contact to the chip carrier, and mechanically holds the package in position. Good alignment of the chip carrier and the mother is possible when solder pads on the chip carrier and mother board are of same size and location, more so when a thick solder layer is used. Solder is usually applied to the mother board as a screen printed paste. The wet solder paste holds the chip carrier in approximate position until the solder melts and floats the chip carrier into place. Chip carriers may be soldered to a mother board while other components are attached. For attaching the chip carrier to the mother board, a furnace or belt soldering equipment is used. Infrared heat may be used in reflow soldering. Side notches or via holes are formed on four sides of the chip carrier in may applications, for connecting the chip carrier to the mother board. The number of these side notches determines the extent of function which can be offered by a semiconductor chip in the carrier, and with an LSI chip a problem arises since an increasing number of side notches are required to realise all chip functions.

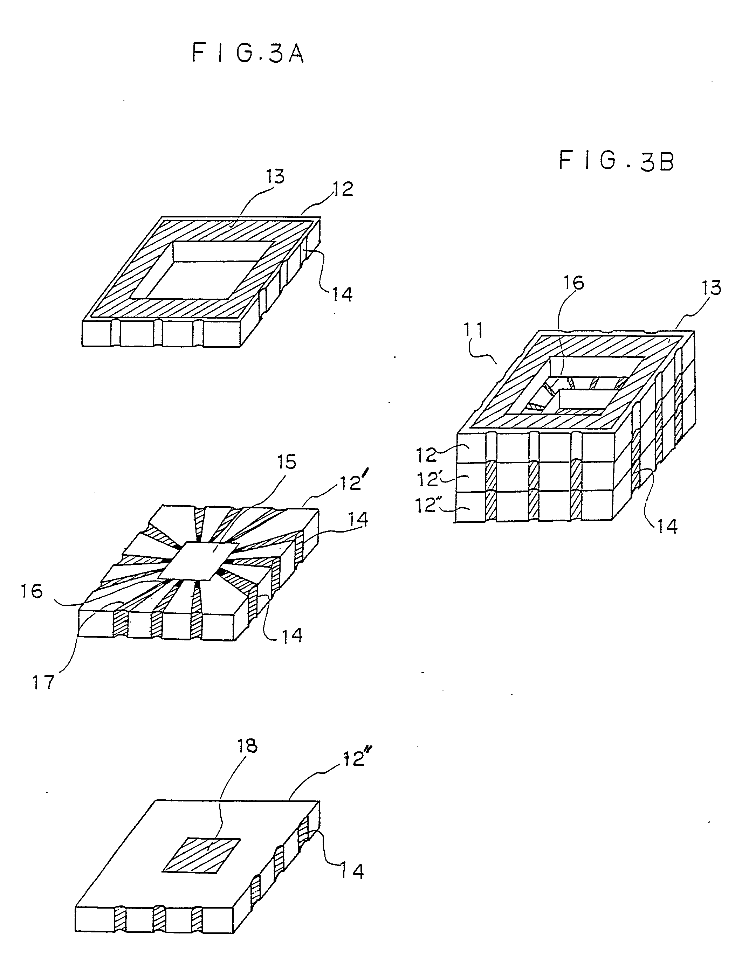

An exploded view of a typical three layer chip carrier is shown in Fig. 3A of the accompanying drawings. The substrates or layers are laminated to form a chip carrier 11 as shown in the perspective view of Fig. 3B of the accompanying drawings.

A top layer 12 is a seal ring having a seal pattern 13 of gold-tin-solder, for mounting a top or cover, not shown. Via holes or side notches 14 are formed on four sides of the seal ring. A second layer 12' shown below the seal ring is formed with a die cavity 15, and side notches 14 on its four sides. Bonding pads 16 are formed to surround the die cavity, and are connected to side notches 14 through traces 17. Bonding pads and traces are made in accordance with a conventional metallization process. The bottom layer 12'' is provided with a die pad 18 to which a chip is secured. The bottom layer 12'' is also provided with side notches 14 which will be connected to a mother board, not shown.

On the other hand, so-called flip chips have been developed. In a flip chip, which is for example a transistor chip not encased in any package, solder bumps are formed on the top surface of the chip. In mounting such a chip on a mother board, the chip is bonded with its top surface downwards onto the mother board, heat is applied to melt the solder bumps to bond the chip to the mother board.

The flip chip dispenses entirely with a package, but a difficult problem is experienced in aligning the bumps on the chip, which are very small, to terminal pads on the mother board. Further, the mounted chip is unprotected and exposed, which reduces reliability of the device into which the flip chip has been incorporated.

DE—A—1,952,789 discloses package structures having external lead pins. In one structure of DE—A—1,952,789 conductor pads (19a, 19b-Figure 1) are provided on the bottom surface of the structure on which lead pins (22a, 22b) are mounted. Contact with external wirings is established through the lead pins. The conductor pads are arrayed in two single files.

GB—A—1,115,302 discloses the mounting of a semiconductor device die, for example a semiconductor diode die, on a base board by soldering.

The article "Buried Wire Multilayer Ceramics", Solid State Technology, May 1971, Vol, 14, No. 5, pages 47 to 50, discloses a variety of multilayer ceramic packages. Leadless packages are mentioned.

According to the present invention there is provided a chip carrier for a semiconductor device having internal pads, for connection to an integrated circuit chip mounted in the chip carrier and external connection pads, connected to the internal pads and for direct contact with external wiring, characterised in that the external connection pads are provided in a lattice array which extends over substantially the whole of external surface of the chip carrier.

An embodiment of the present invention can overcome the problems experienced in the prior art by providing a chip carrier which occupies a small amount of space on the printed circuit board on which it is mounted and in which internal wiring within the package is minimized, to thus reduce the resistance of lead wires.

An embodiment of the present invention can offer a chip carrier having a bottom surface on which are formed a plurality of terminal steps or bumps to be bonded to terminal pads on a mother board with an ease of alignment and soldering. The chip carrier is bonded to the mother board with its top surface uppermost, and this provides for easy handling and mounting of the chip carrier.

An embodiment of the present invention can provide a chip carrier which is well covered and protected, and which provides for reliability in a device having the chip carrier mounted thereon.

An embodiment of the present invention can provide a chip carrier having a sufficient number of terminals for connection to the mother board without being of unduly large size. At the same time, since the chip carrier is large enough, as compared to the chip itself, unlike the case with flip chips, terminal pads on the bottom surface of the substrate are arranged with a sufficient centerline spacing between them to facilitate preparation of the pads. The terminal pads are formed in a lattice arrangement.

Thus, in relation to a chip carrier which encases a semiconductor device such as a large scale integrated (LSI) circuit, an improvement is offered concerning an array of terminal pads for connecting the chip carrier to a mother board.

Reference is made, by way of example, to the accompanying drawings, in which:—

Fig. 1, as mentioned above, provides front and side views of a previously proposed dual-in-line package together with side views of respective modifications thereof.

Fig. 2, as mentioned above, provides front and side views of a previously proposed flat package, with a side view of a modification thereof,

Fig. 3A is an exploded fragmentary view of a previously proposed chip carrier,

and Fig. 3B is a perspective view of the chip carrier illustrated in Fig. 3A when assembled.

Fig. 4A is a view, similar to Fig. 3A, of a chip carrier embodying the present invention, with the bottom layer of the carrier shown upside down, and Fig. 4B is a perspective view of the chip carrier of Fig. 4A when assembled,

Fig. 5 shows respective exploded sectional and perspective views of another chip carrier embodying the present invention,

Fig. 6 is an enlarged schematic sectional view of a terminal step or bump on a ceramic substrate of a chip carrier embodying the present invention, and

Fig. 7 is a schematic cross-sectional view of a chip carrier embodying the present invention positioned above a mother board on which it is to be mounted.

In a chip carrier which is a preferred embodiment of the invention, inner (internal) pads are formed around the periphery of a cavity within which an LSI chip is mounted, and, on the bottom surface of the package, opposite to the inner pads, there are formed a plurality of terminal steps or bumps in a lattice arrangement for connecting the package to a mother board.

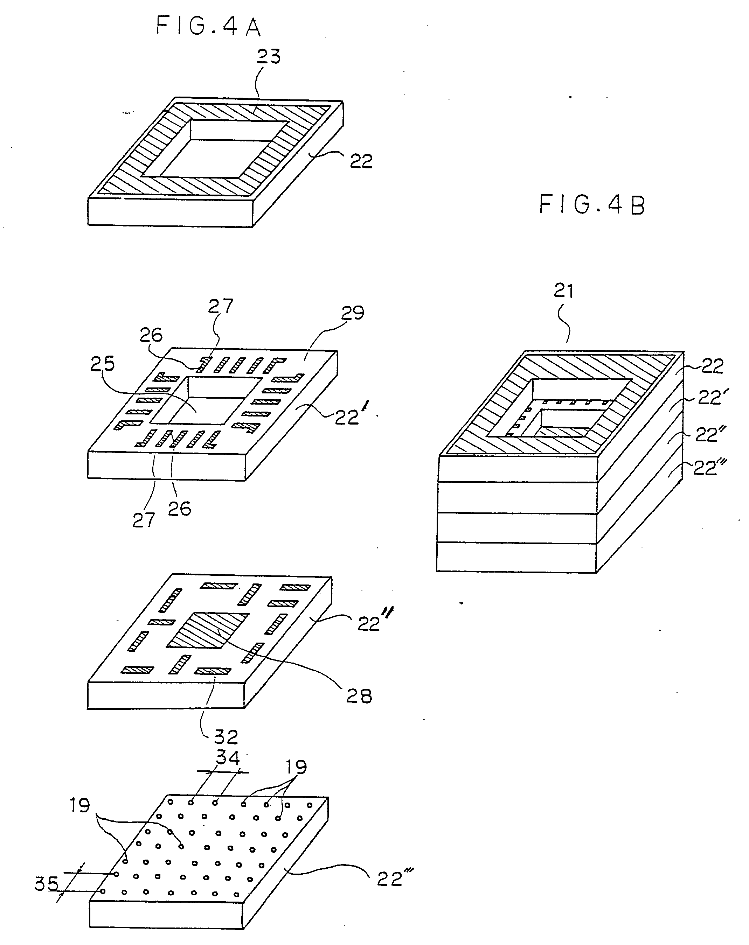

Referring to Fig. 4A, which is an exploded view of a chip carrier 21, comprising ceramic substrate layers and embodying the present invention, with the bottom layer shown upside down, a substantially square seal ring 22 at the top of the carrier has a square opening therein which is larger than a die cavity to be described below. The seal ring 22 has a seal pattern 23 of gold-tin-solder.

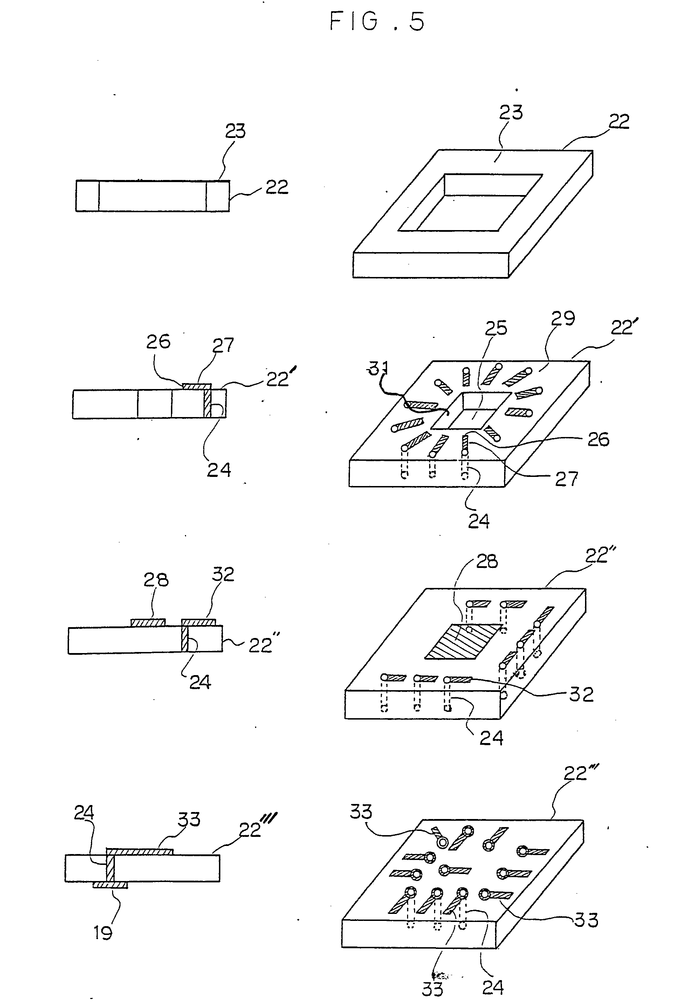

A second layer 22' (second from the top) is also ring shaped like the seal ring 22, and is formed with a square opening therein for the die cavity 25. A predetermined number of inner (or internal) bonding pads 26 and traces 27 are formed on a flat surface 29 to surround the die cavity 25. The traces 27 are led to the bottom surface of the layer 22' through via holes 24 (see Fig. 5).

A third layer 22'' is formed with a die pad 28 centrally of its upper flat surface surrounded by wirings 32 which connect via holes 24 of the second layer 22' to via holes 24 (Fig. 5) of the third layer 22''.

Inner (internal) bonding pads 26 offer surfaces to which bonding wires are connected, while traces 27 provide upper-end surfaces of inner, or internal, wirings of the chip carrier, and both are formed by sintering tungsten, for example, on the flat surface of the substrate or the layer 22''.

Below the layer 22'' in Fig. 4A, bottom layer 22''' of the chip carrier is shown with its top surface downwards. The bottom surface of the layer 22''' has thereon a lattice array of a plurality of leadless external connection pads in form of terminal steps or bumps 19, the lattice having a lateral centerline spacing 34 and a longitudinal centerline spacing 35 as shown, the steps 19 being situated at the crossing points of the lattice. Terminal steps 19 correspond to terminals 2 appearing in Figures 1 and 2. These terminal steps 19 form lower end surfaces of inner, or internal, wirings of the chip carrier. Terminal steps 19 are shown to be circular in form, but they may take any other shapes suitable to effect connection to a mother board. Connection of these terminal steps is usually made by reflow soldering.

Fig. 4B shows a chip carrier 21 formed by laminating together the substrates illustrated in Fig. 4A. It should be pointed out here that although the chip carrier of this embodiment is not formed with side notches such as are seen in Fig. 3B, side notches may be formed if required so that they form, together with steps 19 of the bottom layer, terminals for connection to the outside world.

An outline of a method of manufacture of a chip carrier embodying the present invention will now be described.

In Fig. 5, four layers of ceramic substrates of an embodiment of the invention are shown in exploded views, with a schematic exploded perspective view on the right and a schematic exploded cross-sectional view on the left.

In the manufacture of a chip carrier embodying the present invention, conventional multi-layer ceramic technology is employed. First, alumina powder is mixed with glass frit in a ratio of about 92:8, and the mixture is blended with an organic binder and solvents. Slurry thus obtained is cast on a moving belt which carries the slurry through drying ovens for driving off solvents. Dried, unfired (green) ceramic material is next removed from the belt, and blanked into individual greensheets. This last process is generally called personalization.

Alignment holes are then punched in four corners of each greensheet, followed by precision cluster punch in accordance with the desired via hole pattern.

Metallization is carried out by extruding a paste of tungsten-manganese (W—Mn), molybdenum-manganese (Mo—Mn) or tungsten (W) onto a greensheet. Punched via holes can be metallized when the greensheet surface is metallized according to the desired patten.

Inspected personalized greensheets are stacked according to the predetermined sequence, and laminated together at 50—80°C with a pressure in the order of 25 megapascals. Prior to firing, these green laminates are cut into pieces corresponding to the final ceramic substrates.

The green laminates are sintered in a kiln at 1600°C. Thereafter, baked laminates or substrates are plated to provide the gold-nickel metallization.

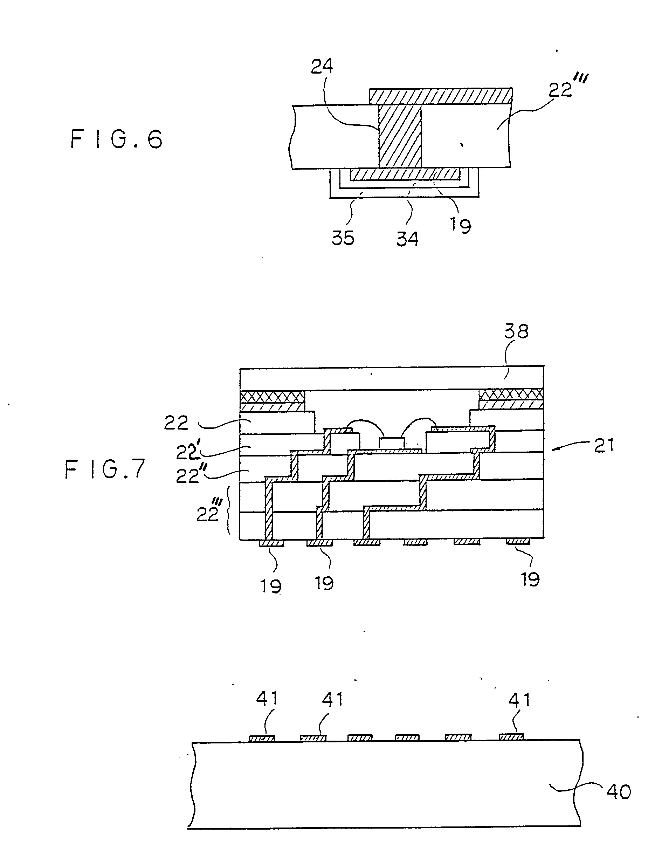

A seal ring 22 which provides a top layer for the carrier has a seal pattern 23 to which a metal cap 38 (Fig. 7) is soldered. A second layer 22' immediately below the layer 22 in Fig. 5 is formed with a cavity 25, surrounded by walls 31, smaller than the opening of the seal ring 22.

Internal pads 26 as well as traces 27 on a flat surface 29 are metallized in accordance with a predetermined pattern, using a screen print. Via holes 24 are also made by means of known mechanical cluster punching and metallization.

An intermediate layer 22'' below the layer 22' has interconnection wiring 32 which can be formed in the same manner as traces 27, and a die pad 28 for receiving an LSI chip (Fig. 7). Via holes 24 connect the wiring 32 to wiring 33 of the bottom layer 22''', to be described.

The bottom layer 22''' serves the purpose of connecting via holes 24 of the intermediate layer 22''' to terminal steps or bumps 19. On its upper surface, the bottom layer 22''' is formed with interconnection wiring 33 connected to via holes 24 which are in turn connected to respective terminal steps or bumps 19 on the bottom surface. Terminal steps 19 are metallized as explained above, and one of such terminal steps is shown in detail in cross-section in Fig. 6. The step or bump 19 is plated with nickel 34 and gold 35. For many usual applications, the bottom layer 22''' may in fact be multi-layer structure, and the number of layers is appropriately selected taking into consideration the number of terminal steps 19.

A chip carrier embodying the present invention can be mounted on a mother board 40 by conventional reflow soldering using eutectic tin-lead solder (63% Sn and 37% Pb) at a temperature in the range of 220—250°C. The chip carrier and the mother board are shown in Fig. 7 in a position in which terminal steps 19 are aligned with terminal pads 41 of the mother board 40. The solder may be placed on terminal steps 19, or on terminal pads 40 of the mother board or on both of them. A chip carrier illustrated in Fig. 7 has a bottom layer 22''' of a two layer structure.

In one chip carrier 21 embodying the present invention, the cavity size is 20 mm x 20 mm, and there are 18 rows of 18 terminal steps. The centerline spacing of the inner pattern of steps or bumps 19 is 0.25 mm, possibly with 320 inner, or internal, pads to form the inner, or internal, pattern. Comparison of this chip carrier with a dual in-line package (DIP), a flat package (FP), a plug in package (PIP) and a chip carrier (CC) according to previous proposals is shown in Table 1 below. Letters in the brackets above are the abbreviations used in the table to indicate different types of package. In the table, comparison is made on the basis that there are 320 or more outer, or external, terminals provided on each carrier or package.

Table 1

|  | centerline spacing (mm) of outer pattern | outer dimension | Ratio of area |
|---|---|---|---|
| chip carrier of the invention | 1.27 (324 terminals) | 25 mm x 25 mm | 1 |
| DIP | 2.54 (320 terminals) | 409 mm x 40 mm | 26 |
| FP | 1.27 (320 terminals) | 102 mm x 102 mm | 16.6 |
| PIP | 2.54 (324 terminals) | 49 mm x 49 mm | 3.8 |
| prior art chip carrier with side notches | 1.02 (320 terminals) | 82 mm x 82 mm | 10.8 |

Note: Outer pattern in the above table means, in the case of the present invention, terminal steps or bumps 19. In the case of DIP, FP, PIP, it means terminals 2 as shown in Figs. 1 and 2. In the case of the previously proposed chip carrier, it means side notches.

The embodiments described so far and shown in the drawings have a ceramic hermetic seal structure, but it is to be understood that a structure embodying this invention is also applicable to chip carriers of a resin seal type. In structures of the latter type, the dimensions given in Table 1 will be reduced accordingly.

A chip carrier embodying this invention will be able to meet the requirements of a chip having several hundred terminals by a rational arrangement of terminal pads and connection of inner (internal) and outer (external) terminals. And thus, the utility of the chip carrier of the present invention should be substantial.

A chip carrier of the present invention as described above is not provided with side notches or side via holes, but it may be manufactured with side notches or via holes, on one or more sides thereof, if desired.

Thus, a chip carrier embodying this invention has an integrated circuits chip sealed therein and comprises layers of ceramic substrates, and terminal steps connected to inner (internal) pads in contact with the integrated circuits chip are provided on the bottom or external surface of at least one layer of the chip carrier preferably the lower-most layer. The terminal steps are provided in a lattice arrangement, with so many rows of terminal steps as equals the number of terminal steps in one row, thus allowing all the terminals of the chip to be connected to outside wirings such as wirings of a mother board.

## Claims

1. A chip carrier for a semiconductor device having internal pads, for connection to an integrated circuit chip mounted in the chip carrier and external connection pads, connected to the internal pads and for direct contact with external wiring, characterised in that the external connection pads are provided in a lattice array which extends over substantially the whole of external surface of the chip carrier.

2. A chip carrier as claimed in claim 1, wherein the external connection pads are respective terminal steps.

3. A chip carrier as claimed in claim 1 or 2, wherein the chip carrier is adapted to be mounted on a mother board by connecting the external connection pads to the mother board by reflow soldering.

4. A chip carrier as claimed in any preceding claim, wherein external connection notches are provided on one or more sides of the chip carrier.

5. A chip carrier as claimed in any preceding claim, having a plurality of ceramic substrate layers provided with the internal pads, wiring pattern and through holes.

6. A chip carrier as claimed in any preceding claim, wherein the external connection pads are formed on the bottom surface of the chip carrier opposite to internal pads.

7. A chip carrier as claimed in any preceding claim, wherein a cap is soldered to a seal ring which is provided by a top layer of the chip carrier.

8. A chip carrier as claimed in claim 5, wherein each layer which constitutes the chip carrier is of a substantially square form.

9. A chip carrier as claimed in claim 2, wherein the terminal steps are arrayed in such a manner that the number of rows of terminal steps is equal to the number of terminal steps in one row.

10. A chip carrier as claimed in claim 9, having integrated circuit chip mounted therein, wherein the total number of terminal steps exceeds the number of terminals of the integrated circuit chip.

## Revendications

1. Support de puce pour dispositif semiconducteur, possédant des plots intérieurs, en vue de la connexion à une puce de circuit intégré montée dans le support de puce, et des plots de connexion extérieurs, connectés aux plots intérieurs, en vue d'un contact direct avec un câblage extérieur, caractérisé en ce que les plots de connexion extérieurs sont disposés suivant un réseau qui s'étend sensiblement sur la totalité d'au moins une surface extérieure principale du support de puce.

2. Support de puce selon la revendication 1, où les plots de connexion extérieurs sont des dents faisant fonction de bornes respectives.

3. Support de puce selon la revendication 1 ou 2, où le support de puce est destiné à être monté sur une plaquette mère par connexion des plots de connexion extérieurs à la plaquette mère par soudage à reflux.

4. Support de puce selon l'une quelconque des revendications précédentes, où des encoches de connexion extérieures sont ménagées sur un ou plusieurs côtés du support de puce.

5. Support de puce selon l'une quelconque des revendications précédentes, possédant plusieurs couches de substrats en céramique dotées des plots intérieurs, d'une configuration de câblage et de trous passants.

6. Support de puce selon l'une quelconque des revendications précédentes, où les plots de connexion extérieurs sont formés sur la surface inférieure du support de puce opposée aux plots intérieurs.

7. Support de puce selon l'une quelconque des revendications précédentes, où un capuchon est soudé à une bague d'étanchéité qui est formée par une couche supérieure du support du puce.

8. Support de puce selon la revendication 5, où chaque couche qui constitue le support de puce est d'une forme sensiblement carrée.

9. Support de puce selon la revendication 2, où les dents faisant fonction de bornes sont disposées en réseau de façon que le nombre de rangées de dents faisant fonction de bornes soit égal au nombre de dents faisant fonction de bornes se trouvant dans une rangée.

10. Support de puce selon la revendication 9, dans lequel est montée une puce de circuit intégré, où le nombre total des dents faisant fonction de bornes dépasse le nombre des bornes de la puce de circuit intégré.

## Patentansprüche

1. Chip-Träger für eine Halbleitervorrichtung, mit internen Anschlußkontakten zum Anschluß an ein integriertes Schaltungschip, welches auf den Chipträger angeordnet ist, und mit äußeren Anschlußkontakten, welche mit den inneren Anschlußkontakten verbunden sind und zum direkten Kontakt mit der äußeren Verdrahtung dienen, dadurch gekennzeichnet, daß die äußeren Verbindungskontakte in einer Gitteranordnung vorgesehen sind, welche sich im wesentlichen über die ganze von wenigstens einer äußeren Hauptoberfläche des Chipträgers erstreckt.

2. Chipträger nach Anspruch 1, bei welchem die äußeren Verbindungskontakte die entsprechenden Anschlußstufen sind.

3. Chipträger nach Anspruch 1 oder 2, bei welchem der Chipträger so ausgebildet ist, daß er auf einer Mutterplatte durch Verbinden der äußeren Verbindungskontakte mit der Mutterplatte durch Rückflußlöten montiert werden kann.

4. Chipträger nach einem der vorhergehenden Ansprüche, bei welchem äußere Verbindungsnuten an einer oder mehreren Seiten des Chipträgers vorgesehen sind.

5. Chipträger nach einem der vorhergehenden Ansprüche, mit einer Anzahl von Keramiksubstratschichten, welche innere Kontakte, Verdrahtungsmuster und Durchgangslöcher aufweisen.

6. Chipträger nach einem der vorhergehenden Ansprüche, bei welchem die äußeren Verbindungskontakte auf der unteren Oberfläche des Chipträgers gegenüber von den inneren Kontakten angeordnet sind.

7. Chipträger nach einem der vorhergehenden Ansprüche, bei welchem eine Kappe an einen Dichtring angelötet ist, welcher durch eine Oberschicht des Chipträgers gebildet ist.

8. Chipträger nach Anspruch 5, bei welchem jede Schicht, welche den Chipträger bildet, im wesentlichen eine quadratische Form hat.

9. Chipträger nach Anspruch 2, bei welchem die Anschlußstufen so angeordnet sind, daß die Anzahl der Reihen der Anschlußstufen gleich der Anzahl der Anschlußstufen in einer Reihe ist.

10. Chipträger nach Anspruch 9, mit einem darauf integrierten Schaltungschip, bei welchem die Anzahl der Anschlußstufen die Anzahl der Anschlüsse des integrierten Schaltungschips übersteigt.

FIG.1

FIG.2

## F I G . 3 A

## F I G . 3 B

FIG.4A

FIG.4B

FIG.5

FIG.6

24

22'''

35  34  19

FIG.7

38

22

22'

22''

22'''

21

19  19  19

41  41  41

40